# EUROPÄISCHE PATENTSCHRIFT

(11) **EP 0 585 622 B1**
(45) Veröffentlichungstag und Bekanntmachung des Hinweises auf die Patenterteilung: **30.10.1996**
(21) Anmeldenummer: 93112309.5
(22) Anmeldetag: 31.07.1993
(51) Int. Cl.: G01D 5/244

(54) **Verfahren bei Längen- oder Winkelmesseinrichtungen**
Method for length or angle measurement devices
Procédé pour appareil de mesure de longueur ou d'angle

(30) Priorität: 04.09.1992 DE 4229575
(43) Veröffentlichungstag der Anmeldung: 09.03.1994
(73) Patentinhaber: Dr. Johannes Heidenhain GmbH, D-83292 Traunreut (DE)
(72) Erfinder: Nelle, Günther, Dr.-Ing., D-83346 Bergen (DE); Holstein, Siegbert, Ing. grad., D-83371 Stein/Traun (DE)

(56) Entgegenhaltungen:
- EP-A- 0 076 861
- WO-A-89/11080
- DE-A- 3 000 378
- DE-A- 3 243 759

## Beschreibung

Die Erfindung bezieht sich auf ein Verfahren bei Längen- oder Winkelmeßeinrichtungen gemäß dem Oberbegriff des Anspruches 1 oder 2.

Derartige Verfahren werden insbesondere bei Bearbeitungsmaschinen zur Messung der Relativlage eines Werkzeugs bezüglich eines zu bearbeitenden Werkstücks sowie bei Koordinatenmeßmaschinen zur Ermittlung von Lage und/oder Abmessungen von Prüfobjekten eingesetzt.

Bei den zu solchen Messungen dienenden Meßeinrichtungen wird zwischen inkrementalen Längen- oder Winkelmeßeinrichtungen und absoluten Längen- oder Winkelmeßeinrichtungen unterschieden.

Eine inkrementale Wegmeßeinrichtung weist einen Teilungsträger mit einer inkrementalen Teilung auf, die von einer Abtasteinrichtung zur Erzeugung von periodischen Abtastsignalen abgetastet wird, aus denen in einer Auswerteeinrichtung Zählimpulse für jedes Teilungsinkrement oder nach elektronischer Interpolation für einen Bruchteil eines Teilungsinkrementes gewonnen werden. Die Zählung dieser Zählimpulse in einem Zähler liefert den momentanen Positionsmeßwert und erfolgt jeweils von frei wählbaren Meßbezugslagen dieser inkrementalen Teilung ausgehend; diesen Meßbezugslagen können zur gegenseitigen Unterscheidung codierte Referenzmarken zugeordnet sein, deren Lagen bestimmten Positionen fest zugeordnet sind.

Eine derartige Positionsmeßeinrichtung und ein Verfahren zur Meßwertbildung ist aus der WO 89/11080 bekannt. Dort wird folgendes beschrieben:

Um in einer Positionsmeßeinrichtung praktisch jederzeit ein lagecodiertes Signal zu erzeugen, werden zwei Spuren mittels zweier Sensoren abgetastet, die je ein sinusförmiges Signalpaar (cos α; sin α; cos β, sin β) oder ein ähnliches periodisches Signal mit einer jederzeit definierten Phasenlage erzeugen, deren Periodenlänge sich wie n/n+1 verhalten. Der gesuchte Relativabstand ergibt sich dann als Differenz der beiden Phasenlagen.

Der Erfindung liegt die Aufgabe zugrunde, ein Verfahren anzugeben mit dem eine Meßeinrichtung zur dynamischen absoluten Positionsbestimmung betrieben werden kann, wobei inkrementale Meßsignale bei mehrspurigen Meßeinrichtungen sequentiell ermittelt und korrigiert werden.

Diese Aufgabe wird mit einem Verfahren gelöst, das die Verfahrensschritte des Anspruches 1 oder 2 enthält.

Die Vorteile des erfindungsgemäßen Verfahrens liegen darin, daß mit wenigen Inkrementalspuren eine absolutcodierte Position bei großer Meßlänge und mit hoher Auflösung bestimmt werden kann, wobei die Signale jeder Inkrementalspur interpolationsgeeignet sind und die Interpolationswerte jeder Spur bei dynamischer Abtastung korrigiert werden. Aufwendige Sample- and Hold-Glieder für jede Spur können entfallen.

Mit Hilfe von Ausführungsbeispielen wird die Erfindung anhand der Schema-Zeichnungen noch näher erläutert:

Es zeigt
- Figur 1: die Kernmerkmale einer Längenmeßeinrichtung und
- Figur 2: eine Maßverkörperung mit Bezugsspur.

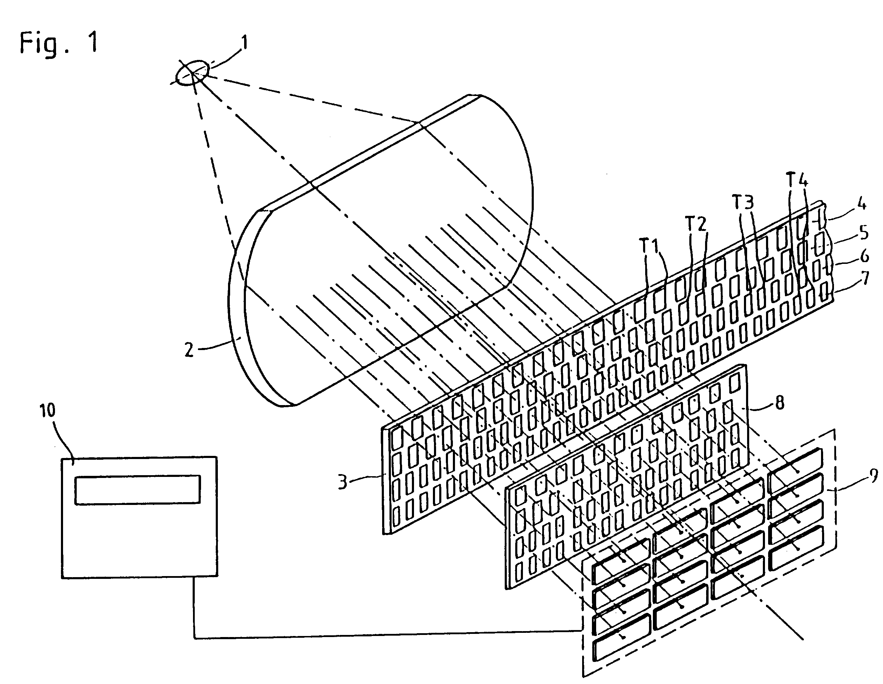

Eine in Figur 1 dargestellte Längenmeßeinrichtung weist eine Beleuchtungsquelle 1 und einen Kondensor 2 auf, die paralleles Licht auf eine Maßverkörperung 3 richten. Die Maßverkörperung 3 weist vier Spuren mit Meßteilungen 4, 5, 6 und 7 auf, deren Teilungsperioden sich voneinander unterscheiden.

Des weiteren ist eine Abtastplatte 8 und eine Detektoreinheit 9 vorgesehen, deren Abtast- und Detektorfelder den Meßteilungen angepaßt und zugeordnet sind. Eine Auswerteeinrichtung trägt das Bezugszeichen 10.

Jede Spur der Meßteilungen 4, 5, 6 und 7 wird in bekannter Weise mit vier um 1/4 Teilungsperiode zu einander versetzten Abtastfeldern abgetastet. Dadurch werden in bekannter Weise je Spur aus jeder Meßteilung 4, 5, 6 und 7 zwei um 1/4 Teilungsperiode zueinander versetzte sinusförmige Signale erzeugt, die in vorbestimmbaren Schritten interpolationsfähig sind.

Eine geeignete Abstufung der Teilungsperioden zueinander ermöglicht eine besonders einfache und zuverlässige Auscodierung des zu ermittelnden absoluten Positionswertes. Die mathematischen Zusammenhänge der Teilungsabstufungen sind in geeigneter Weise zu wählen.

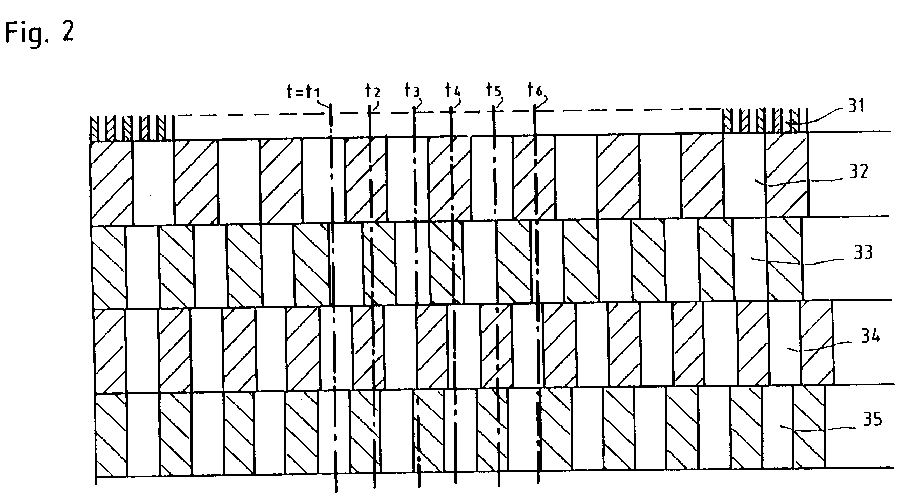

Figur 2 zeigt eine Maßverkörperung 3, deren Meßteilungen 31, 32, 33, 34 und 35 nach einem Schema abgestuft sind, das in einer nicht vorveröffentlichten Anmeldung mit dem Aktenzeichen P 41 25 865.7 (EP-A-0526730) beschrieben ist. Aus zeichentechnischen Gründen ist das Prinzip allerdings stark übertrieben dargestellt worden.

Für die Erläuterung der dynamischen Abtastung sind verschiedene Ableselinien t in strichpunktierter Form eingezeichnet.Der Abstand der Ableselinien t in Meßrichtung resultiert aus der Verfahrgeschwindigkeit beim relativen Verfahren von Abtastplatte 8 und Maßverkörperung 3 und verdeutlicht die unterschiedlichen Ablesezeitpunkte.

Zum Zeitpunkt der ersten Ablesung befindet sich die in Figur 1 gezeigte Abtastplatte 8 zur Abtastung der ersten Spur 31 auf der Ableselinie t gleich t1. Durch die Verfahrbewegung zwischen Abtastplatte 8 und Maßverkörperung 3 befindet sich die Abtastplatte 8 bei der Abtastung der zweiten Spur 32 auf der Ableselinie t2, u.s.w..

Nach der sequentiellen Abtastung aller Spuren liegen für die einzelnen Spuren 31, 32, 33, 34, und 35 jeweils Meßwerte vor, die sich um einen Verschiebungsbetrag vom Meßwert der ersten abgelesenen Spur unterscheiden.

Nachdem alle Spuren abgetastet sind, wird zusätzlich ein zweites Mal die erste Spur 31 abgetastet und ein zweiter Meßwert für diese Spur erzeugt. Dieser zweite Meßwert entsteht zu einem Zeitpunkt, in welchem sich die Abtastplatte 8 an der Ableselinie t6 befindet und wird mit dem ersten Meßwert aus der ersten Abtastung bei t1 verrechnet. Diese Wegdifferenz wird abgespeichert.

Bei hinreichend gleichmäßiger Verfahrgeschwindigkeit, d.h., bei konstanten Zeitabständen zwischen den Messungen in den einzelnen Spuren 31, 32, 33, 34 und 35, werden aus der Wegdifferenz der beiden Messungen der ersten Spur 31 und aus den Verhältnissen der Zeiten der Messungen der ersten und der weiteren Spuren Korrekturwerte für die Meßwerte aller Spuren ermittelt. Damit wird sichergestellt, daß alle Meßwerte auf den Zeitpunkt der ersten Messung an der Ableselinie t1 in der ersten Spur 31 zurückgeführt sind. Durch diese Maßnahme werden die Meßwerte unabhängig vom Zeitpunkt der tatsächlichen Ablesung, da unabhängig von einer Relativbewegung zwischen dem Maßstab 3 und der Abtastplatte 8 derselbe Ablesezeitpunkt - nämlich der an der Ableselinie t1 - für alle Spuren gilt.

Aus den auf diese Weise korrigierten Meßwerten der einzelnen Spuren 31, 32, 33, 34 und 35 zu den unterschiedlichen Ablesezeitpunkten an den Ableselinien t1 bis t6 wird ein codierter Positionswert zum Zeitpunkt der ersten Ablesung an der Ableselinie t1 der ersten Spur 31 berechnet.

Bei bekannten Zeitdifferenzen zwischen den Ablesungen der einzelnen Spuren kann über die Relativgeschwindigkeit aus der Zeit zwischen den Ablesungen der Bezugsspur und den weiteren Spuren direkt der Weg zwischen diesen Ablesungen und damit ein Korrekturwert für die Ablesungen ermittelt werden kann.

## Patentansprüche

1. Verfahren zum Ablesen einer Maßverkörperung (3) einer Längen- oder Winkelmeßeinrichtung, wobei die Maßverkörperung (3) mehrere Spuren (31, 32, 33, 34, 35) mit Meßteilungen unterschiedlicher Teilungsperioden aufweist, die mittels einer relativ zur Maßverkörperung (3) verfahrbaren Abtastplatte (8) bei gleichmäßiger Verfahrgeschwindigkeit sequentiell abgelesen werden, dadurch gekennzeichnet, daß beginnend mit einer ersten Ableselinie (t₁) bei der Spur (31) mit der kleinsten Teilungsperiode als Bezugsspur die Meßwerte in jeder weiteren Spur (32 bis 35) sequentiell an verschiedenen Ableselinien (t₂ bis t₅) ermittelt und zahlenmäßig abgespeichert werden, daß nach dem Ablesen aller weiteren Spuren (32 bis 35) die Bezugsspur (31) an einer weiteren Ableselinie (t6) nochmals abgelesen und eine Wegdifferenz zwischen der ersten Ablesung und der zweiten Ablesung der Bezugsspur (31) aufgrund der unterschiedlichen Ablesezeitpunkte ermittelt wird, wobei aus dieser Wegdifferenz unter Berücksichtigung der Anzahl der sequentiell abgelesenen Spuren (31 bis 36) Korrekturwerte für die Meßwerte der einzelnen Spuren (32 bis 35) errechnet werden, die eine Korrektur des Meßwertes bei den Ableselinien (t₂ bis t₅) in den einzelnen Spuren (32 bis 35) durch Rückführung auf den Meßwert bei der ersten Ablesung der Bezugsspur (31) bewirken.

2. Verfahren zum Ablesen einer Maßverkörperung (3) einer Längen- oder Winkelmeßeinrichtung, wobei die Maßverkörperung (3) mehrere Spuren (31, 32, 33, 34, 35) mit Meßteilungen unterschiedlicher Teilungsperioden aufweist, die mittels einer relativ zur Maßverkörperung (3) verfahrbaren Abtastplatte (8) abgelesen werden, dadurch gekennzeichnet, daß die Meßwerte aller Spuren (31 bis 35), beginnend bei der ersten Spur (31) nach einem Abrufimpuls hintereinander in bekannten Zeitabständen abgelesen und abgespeichert werden und daß aus der Relativgeschwindigkeit zwischen Maßverkörperung (3) und Abtastplatte (8) und aus der Zeit zwischen den Ablesungen der einzelnen Spuren (31 bis 35) der jeweilige Weg zwischen diesen Ablesungen ermittelt und daraus ein Korrekturwert bezogen auf die erste Ablesung ermittelt wird.

## Claims

1. A method of reading a measuring unit (3) of a length or angle measuring device, wherein the measuring unit (3) has a plurality of tracks (31, 32, 33, 34, 35) with different graduation periods, which are read sequentially at a uniform speed of displacement by means of a sensing plate (8) movable relative to the measuring unit (3), characterized in that, beginning with the a first reading line (t₁) for the track (31) with the smallest graduation period as reference track, the measured values in each further track (32 to 34) are determined at different reading lines (t₂ to t₅) and are stored by number, in that after reading all of the further tracks (32 to 35), the reference track (31) is read again at a further reading line (t₆) and a displacement difference between the first reading and the second reading of the reference track (31) is determined on the basis of the different instants of reading, wherein correcting values for the measurement values of the individual tracks (31 to 35) are computed from this displacement difference, taking into account the numbers of the sequentially read tracks (31 to 35), which effect a correction of the measured value for the reading lines (t₂ to t₅) in the individual tracks (32 to 35) related back to the measured value in the first reading of the reference track (31).

2. A method of reading a measuring unit (3) of a length or angle measuring device, wherein the measuring unit (3) has a plurality of tracks (31, 32, 33, 34, 35) with different graduation periods, which are read by means of a sensing plate (8) movable relative to the measuring unit (3), characterized in that, beginning with the first track (31), the measured values of all tracks (31 to 35) are read one after the other at known intervals of time after a trigger pulse and are stored, and in that from the relative speed between the measuring unit (3) and the sensing plate (8) and from the times between the readings of the individual tracks (31 to 35) the corresponding displacements between these readings are determined and correction values relative to the first reading are determined therefrom.

## Revendications

1. Procédé de lecture d'une règle de mesure (3) d'un dispositif de mesure de longueurs ou d'angles, la règle de mesure (3) comportant plusieurs pistes (31, 32, 33, 34, 35) avec des graduations de mesure de période différente qui sont lues de manière séquentielle, avec une vitesse de déplacement régulière, au moyen d'une plaque de lecture (8) mobile par rapport à la règle de mesure (3), caractérisé par le fait que commençant par une première ligne de lecture (t₁), à la piste (31) présentant la plus faible période de graduation comme piste de référence, on détermine les valeurs de mesure dans chaque autre piste (32 à 35) de manière séquentielle sur différentes lignes de lecture (t₂ à t₅) et on les mémorise sous forme de nombres, par le fait qu'après avoir lu toutes les autres pistes (32 à 35), on lit de nouveau la piste de référence (31) au niveau d'une autre ligne de lecture (t₃) et on détermine une course différencielle entre la première lecture et la deuxième lecture de la piste de référence (31) résultant des instants de lecture différents, des valeurs de correction pour les valeurs de mesure des différentes pistes (32 à 35) étant calculées à partir de cette course différentielle en tenant compte du nombre de pistes (31 à 36) lues de manière séquentielle, valeurs de correction qui provoquent une correction de la valeur de mesure pour les lignes (t₂ à t₅) dans les différentes pistes (32 à 35) par rétroaction sur la valeur de mesure de la première lecture de la piste de référence (31).

2. Procédé de lecture d'une règle de mesure (3) d'un dispositif de mesure de longueurs ou d'angles, la règle de mesure (3) comportant plusieurs pistes (31, 32, 33, 34, 35) avec des graduations de mesure de période différente qui sont lues au moyen d'une plaque de lecture (8) mobile par rapport à la règle de mesure (3), caractérisé par le fait qu'après une impulsion de déclenchement, on lit successivement, à intervalles connus, les valeurs de mesure de toutes les pistes (31 à 35) en commençant àla première piste (31) et on les mémorise, et par le fait qu'à partir de la vitesse relative entre la règle de mesure (3) et la plaque de lecture (8) et du temps écoulé entre les lectures des différentes pistes (31 à 35), on détermine la course entre les lectures et, à partir de celle-ci, une valeur de correction rapportée à la première lecture.
